# EUROPEAN PATENT SPECIFICATION

(11) **EP 1 622 262 B1**
(45) Date of publication and mention of the grant of the patent: **20.02.2008**
(21) Application number: 04018019.2
(22) Date of filing: 29.07.2004
(51) Int. Cl.: H03G 3/30, H04B 7/005

(54) **RF unit and method for power control to be used in a radio communication equipment**
HF-Baugruppe und Verfahren zur Leistungsregelung zur Verwendung in einer Funkkommunikationseinrichtung
Unité radiofréquence et procédé de commande de puissance utilisable dans un équipement de radio-communication

(43) Date of publication of application: 01.02.2006
(73) Proprietor: Sony Ericsson Mobile Communications AB, 221 88 Lund (SE)
(72) Inventor: Karlsson, Thomas, 224 74 Lund (SE)
(74) Representative: Körber, Martin Hans

(56) References cited:
- EP-A- 1 309 094
- EP-A- 1 343 254
- DE-A- 10 004 434
- US-B1- 6 236 863
- US-B2- 6 759 902

## Description

### TECHNICAL FIELD OF THE INVENTION

The present invention relates to an RF unit and a method to be used in a radio communication equipment comprising the features of the preambles of independent claims 1 and 12, respectively.

In the technical field of radio communication equipments such as mobile telephones, pagers, communicators, electronic organisers, smartphones or the like, wireless communication has been broadly established. The RF unit is a crucial element of said radio communication equipments since it generates an RF output signal used in wireless communication and processes an RF input signal received by said radio communication equipment.

In the recent years the ability of radio communication equipments and thus RF units to communicate according to more than one communication standard has been increased due to the different communication standards throughout the world. Thus, modem radio communication equipments are adapted to communicate via plural transmission frequency bands and plural corresponding receiving frequency bands.

Different output powers are used for wireless communication according to the respective communication standards.

In a typical radio communication equipment the maximum power of the RF output signal output by the radio communication equipment varies (e.g. due to temperature variations of the components of the radio communication equipment).

For example, the maximum power of an RF output signal output by a radio communication equipment varies by ± 1.3 dB due to temperature variations of the components. This results for a radio communication equipment being trimmed to a maximum power of 22.5 dBm of the RF output signal in a variation of the maximum power of between 21.2 dBm and 23.8 dBm.

In this respect, it has to be mentioned that a constant transmitting phone like a class 3 UMTS phone has a 9 dB higher average power of the RF output signal output by the radio communication equipment when compared with a GSM phone that only transmits 12.5 % of the total time. In consequence, a UMTS phone having a maximum power of the RF output signal of 21 dBm is equivalent with a GSM 1800 mobile phone having a maximum power of the RF output signal of 30 dBm.

For the sake of completeness it is noted that the last letter "m" of the unit dBm refers to the reference level used, in this case to 1 mW and thus milliwatt.

### DESCRIPTION OF RELATED ART

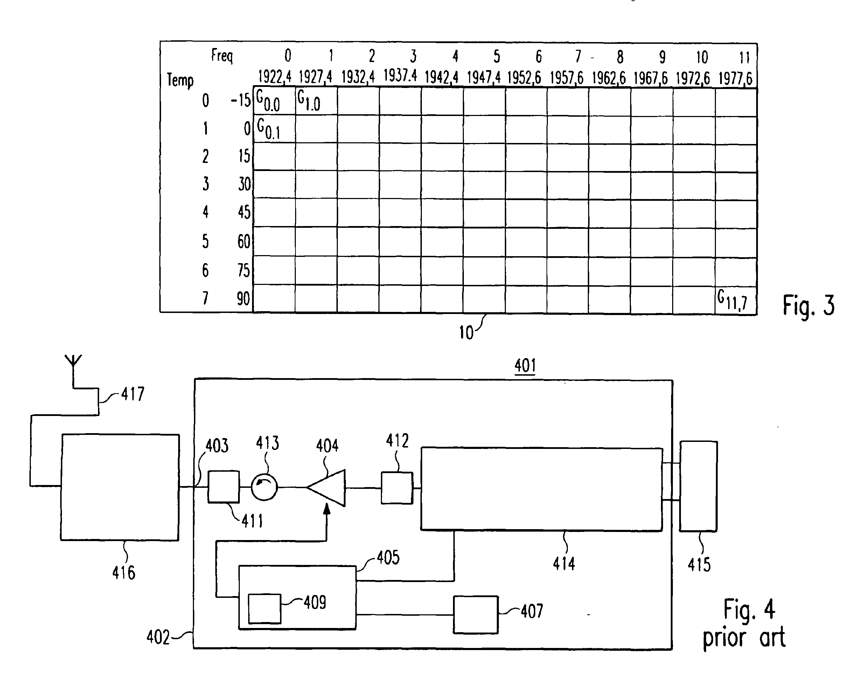

In the following, the control of the power of the RF output signal output by a radio communication equipment according to the prior art is explained in more detail by reference to Fig. 4. In the present example, said radio communication equipment is a mobile telephone.

It has to be emphasised that the following description is only exemplary to show a typical radio communication equipment according to the prior art. Other ways of controlling the power of the RF output signal output by the radio communication equipment according to the prior art might be used.

The mobile telephone 401 according to the prior art comprises among other elements an RF unit 402, that is connected to an antenna switch 416 with at least one antenna 417 and to an auxiliary means 415 by suitable signal lines. Since both the internal structure of the auxiliary means 415 such as input/output means, battery means etc. and the internal structure of the antenna switch 416 are of less significance for the present patent application, only the function of the RF unit 402 of the mobile telephone 401 is explained in more detail.

The RF-unit 402 basically comprises an RF signal processor 414.

Said RF signal processor 414 firstly processes RF input signals input by said antenna switch 416 and outputs a suitable output signal to the auxiliary means 415.

Secondly, the RF-signal processor 414 processes signals input to the RF-signal processor by the auxiliary means 415 and generates a suitable RF signal based on the input signal. The RF-signal generated by the RF-signal processor is output to a second band-pass filter 412. Further, the RF signal processor outputs a frequency information corresponding to the frequency of the RF-signal output to the second band-pass filter 412 to a power controller 405 of the RF unit 402.

The power controller 405 is adapted to control an adjustable amplifier 404 to variably amplify the RF-signal output by the second band-pass filter 412 to generate an RF output signal.

The RF output signal amplified by the adjustable amplifier 404 is output via a gyrator 413 and a first band-pass filter 403 via a signal line 403 to the antenna switch 416.

In the following, it is further explained how the power of the RF output signal is controlled by the power controller 405 of the mobile telephone 401 according to the

### prior art.

The power controller 405 comprises an internal memory 409. A gain compensation table is stored in the internal memory 409 of the power controller 405.

A typical gain compensation table 10 is shown in Fig. 3.

As it is shown i Fig. 3, the compensation table 10 comprises different gain correction values G_{0,0} to G_{11,7} for 11 frequency values wherein a different gain compensation value is given for 8 typical temperature values.

A temperature sensor 407 that is adapted to measure the temperature of the RF unit 402 and to output a corresponding temperature signal is connected to the power controller 405.

By using the frequency information received from the RF signal processor 414 and the actual temperature signal received from the temperature sensor 407 the power controller 405 is adapted to choose a corresponding gain correction value G_{0,0} to G_{11,7} out of the gain compensation table 10. By using said gain correction value, the power of the RF signal output by the RF signal processor 414 is controlled by adjusting the adjustable amplifier 404. The correspondingly generated RF output signal is output to the antenna switch via said gyrator 413 and said first band-pass filter 411.

In consequence, according to the prior art, the power of the RF output signal output by the RF unit 402 is controlled by using frequency and temperature information in dependency on a predefined gain compensation table 10, only. Thus, the power of the RF output signal output by the RF unit 402 is controlled by an open loop control.

The reason for using an open loop control instead of a closed loop control is that a closed loop control would be very complex due to the high dynamic of the power of the RF output signal output by the RF unit 402.

The usage of an open loop control results in plural disadvantages. The temperature dependency of the RF signal processor 414 is very high. In consequence, it is very difficult to provide a reliable gain compensation table to compensate for said temperature variations. Furthermore, the temperature sensor 407 is not totally accurate. Due to the high temperature gain sensitivity an error of the temperature sensor 407 results in a significantly wrong power of the RF output signal. Moreover, dynamic temperature changes of the RF signal processor 414 and / or the adjustable amplifier are very hard to measure by the temperature sensor 407. This frequently results in a difference between the measured temperature and the true temperature of about 3°C.

US 6,759,902 B2 discloses an automatic gain control circuit for an RF amplifier which has a single, switched, RF detector that selectively detects the instantaneous power level of either the sampled RF input signal or the sampled RF output signal. A processor uses the detected input and output power levels to generate control signals for a variable attenuator that attenuates the RF input signal prior to being applied to the input of the RF amplifier. The automatic gain control circuit can operate in an open loop mode and in a closed loop mode.

EP 1 309 094 A1 discloses a similar transmission power control circuit with a variable gain amplifier.

The before-cited disadvantages of the control of the power of the RF output signal by a radio communication equipment according to the prior art result in high variations of the intended maximum power of the RF output signal of usually more than 1.2%.

It is the object of the present invention to overcome the above cited disadvantages of the prior art and to provide an RF unit and a method to be used in a radio communication equipment which provide an easy and more accurate control of the power of the RF output signal generated by the RF unit that can be realised by using cheap components.

The above object is solved in a radio communication equipment comprising the features of the preamble of independent claim 1 by the features of the characterising part of claim 1.

Furthermore, the above object is solved with a method for controlling a radio communication equipment comprising the features of the preamble of independent claim 11 by the features of the characterising part of claim 11.

Further developments are set forth in the dependent claims.

It should be emphasised that the term "comprises / comprising" when used in this specification is taken to specify the presence of stated features, integers, steps or components but does not preclude the presence or addition of one or more other features, integers, steps, components or groups thereof.

The above object is solved by an RF unit to be used in a radio communication equipment for wireless communication, according to claim 1 the RF unit being adapted to generate an RF output signal and to output said RF output signal via a signal line, wherein said RF unit comprises at least one adjustable amplifier for amplifying the RF output signal and outputting said RF output signal via said signal line and a power controller for controlling the power of the RF output signal amplified by said amplifier by adjusting said adjustable amplifier, the adjustment of said adjustable amplifier being performed by said power controller by an open loop control. According to the present invention the RF unit further comprises a power detector coupled to said signal line, the power detector outputting a detection signal depending on the power of the RF output signal transmitted via said signal line to said power controller, wherein the detection signal output by said power detector is used by said power controller to adjust said adjustable amplifier by a closed loop control if the power of the RF output signal exceeds a predefined threshold value stored in said power controller.

By the provision of a power detector coupled to said signal line and by the use of the detection signal output by said power detector a closed loop control of the power of the RF output signal output by the RF unit is provided. In consequence, the accuracy of controlling the power of the RF output signal is limited by the accuracy of the power controller, the power detector and the adjustable amplifier, only.

The exclusive usage of an open loop control if the power of the RF output signal is below said threshold value allows a relatively easy control of the power of the RF output signal with high dynamic.

By the inventive combination of said open loop control with a closed loop control being used if the power of the RF output signal exceeds said threshold value, only, the accuracy of said control significantly can be increased for critical power ranges of the RF output signal. Since control by said closed loop control is limited to a narrow range (if the power of the RF output signal exceeds said threshold value) the closed loop control does not have to scope with high ranges of dynamic. In consequence, a simple and thus cheap closed loop control can be used.

Moreover, the inventive solution requires only a small amount of additional elements. In consequence, the additional costs are very low.

According to the invention, the predefined threshold value is defined in the proximity of a maximum power of the RF output signal amplified by said amplifier below said maximum power of the RF output signal.

Thus, the threshold value can be used to restrict adjustment of the adjustable amplifier by using the power detector to a power range of the RF output signal close to the intended maximum output power.

The reason is that control of the maximum power of the RF output signal is much more critical than control of the range in-between the maximum power and a minimum power. Furthermore, control of the power of the RF output signal in the vicinity of the maximum power of the RF output signal by an open loop control normally is less accurate due to temperature dependencies of the elements.

It is preferred that the open loop control is performed by said power controller independent from the actual power of the RF output signal amplified by said amplifier according to predefined rules.

This independence from the signal that has to be controlled is typical for an open loop control.

It is beneficial if the power detector is a directional coupler coupled to said signal line.

In this respect it is important to emphasise that a directional coupler is an element having a relative high power dynamic and a low temperature variation. Furthermore, the influence of the directional coupler on the RF output signal is very small.

Favourably the power controller compares the detection signal output by said power detector with a predefined threshold value and adjusts the adjustable amplifier based on a difference between said threshold value and the detection signal output by said power detector.

The use of a difference between a threshold value and a coupled signal output by a power detector firstly allows a linear adjustment of the RF output signal in dependency on the aberration from the threshold value.

Preferably the power controller further comprises a temperature sensor for measuring the temperature of the RF unit and outputting a corresponding temperature signal,
wherein the temperature signal output by said temperature sensor is used by said power controller to adjust the adjustable amplifier.

Thus, the influence of temperature variations on the adjustable amplifier and the further components of the RF unit still can be accounted for.

It is profitable if the power controller further comprises a frequency sensor for measuring the frequency of the RF output signal transmitted via said signal line and outputting a frequency signal, wherein the frequency signal output by said frequency sensor is used by said power controller to adjust the adjustable amplifier.

By using a frequency signal output by the frequency sensor to adjust the adjustable amplifier a frequency dependency in the gain of the adjustable amplifier or other components of the RF-unit can be accounted for.

According to a preferred embodiment of the present invention the power controller further comprises a memory for storing at least one predefined gain compensation table, said gain compensation table comprising predefined gain compensation values for predefined frequency and / or temperature values, wherein the gain compensation values of said gain compensation table stored in said memory are used by said power controller to adjust the adjustable amplifier depending on the respective frequency signal output by the frequency sensor and / or the respective temperature signal output by the temperature sensor.

The usage of a predefined gain compensation table reduces the necessary calculations for performing power control by the power controller and thus increases the velocity of gain control and thus provides an easy and reliable open loop control. Furthermore, frequency dependencies or temperature dependencies of the various elements of the RF unit (that e.g. might have been analysed in a laboratory) can be accounted for. In consequence, even in cases where the power detector is not used for power control to adjust the adjustable power amplifier a suitable power control of the power of the RF output signal is guaranteed.

Favourably the detection signal output by the power detector is used by the power controller to correct the respective compensation values of a respective gain compensation table for the respective frequency signal output by the frequency sensor and / or the respective temperature signal output by the temperature sensor.

A correction of the respective compensation values of a respective gain compensation table for the respective frequency signal and/or the respective temperature signal by using the detection signal output by the power detector allows an integration of the power detector into common power control architectures in a very easy way. Thus, a closed loop control can be integrated in an existing open loop control in a very easy way.

It is preferred that the RF unit is connected via the signal line to a sending / receiving unit of a radio communication equipment for wireless sending and receiving of an RF signal, wherein said RF unit is adapted to output the RF output signal to said sending / receiving unit via said signal line.

By the provision of the power detector at the signal line between the RF unit and the antenna switch it is guaranteed that the effective power of the RF output signal of the RF unit is detected by the power detector and used for control of the adjustable amplifier.

Profitably the RF unit is comprised in a mobile radio terminal.

Furthermore, the above object is solved by a method of controlling the power of an RF output signal output by an RF unit according to claim 11, wherein said RF unit comprises at least one adjustable amplifier for amplifying the RF output signal, the method comprising the following steps:
- measurement of the power of the RF output signal output by said RF unit;
- comparison of the measured power of the RF output signal with a predefined threshold value;
- adjustment of the adjustable amplifier by an open loop control if the measured power of the RF output signal is below the predefined threshold value; and
- adjustment of the adjustable amplifier by a closed loop control in dependency on the measured power of the RF output signal if the measured power of the RF output signal exceeds the predefined threshold value, whereby said predefined threshold value is defined in the proximity of a maximum power of the RF output signal below said maximum power of the RF outputsignal.

Thus, a combination of both an open loop control and a closed loop for controlling different ranges of the power of an RF output signal of an RF unit can be provided with ease. In consequence, variances of the power of the RF output signal can be reduced for critical ranges of the power of the RF output signal.

It is preferred that said adjustment of the adjustable amplifier by an open loop control is performed independent from the measured power of the RF output signal according to predefined rules.

Preferably the measurement of the power of the RF output signal is performed by using a directional coupler outputting a detection signal depending on the power of the RF output signal.

Favourably the method further comprises the step of:
- measuring of a temperature of the RF unit and / or a frequency of the RF output signal output by said RF unit;
wherein the adjustment of the adjustable amplifier is performed according to the result or the temperature and / or frequency measuring.

According to a preferred embodiment the method further comprises the step of:
- loading of a predefined gain compensation table, said gain compensation table comprising predefined gain compensation values for predefined frequency and / or temperature values;
wherein the adjustment of the adjustable amplifier is performed by using said gain compensation values of said gain compensation table according to the actual result or the temperature and / or frequency measuring.

In this respect it is beneficial if the method further comprises the step of
- correction of the respective compensation values of said gain compensation table according to said measured power of the RF output signal for the actual result or the temperature and / or frequency measuring if the measured power of the RF output signal exceeds the predefined threshold value,
wherein the adjustment of the adjustable amplifier is performed by using said corrected gain compensation values of said gain compensation table corresponding to the actual result of the temperature and / or frequency measuring if the measured power of the RF output signal exceeds the predefined threshold value.

Furthermore, the above object is solved by a computer program product comprising a series of state elements which are adapted to be processed by a data processing means of a radio communication equipment such, that a method according to the present invention may be executed thereon.

Thus, the inventive method can be implemented into common radio communication equipments with ease.

### BRIEF DESCRIPTION OF THE DRAWINGS

In the following detailed description, the present invention is explained by reference to the accompanying drawings, in which like reference characters refer to like parts throughout the views, wherein:
- Fig. 1: shows a block diagram of a radio communication equipment according to a preferred embodiment of the present invention;
- Fig. 2: shows a flow diagram of a preferred embodiment of the inventive method of controlling the power of an RF output signal output by an RF unit;
- Fig. 3: shows a typical compensation table to compensate frequency and temperature dependencies in an RF unit; and
- Fig. 4: shows a block diagram of a mobile telephone according to the prior art.

### DETAILED DESCRIPTION OF EMBODIMENT

In the following description the term radio communication equipment includes portable radio communication equipment. The term portable radio communication equipment, which herein after is referred to as a mobile radio terminal, includes all equipment such as mobile telephones, pagers, communicators, i.e. electronic organisers, smartphones or the like.

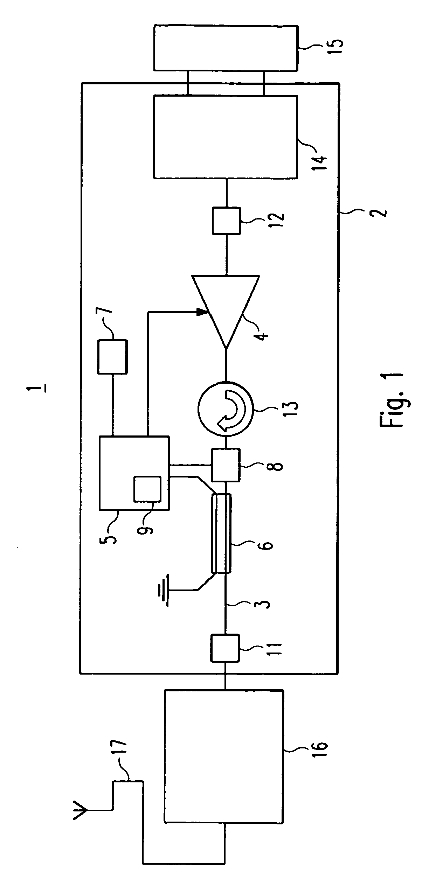

Fig. 1 shows a block diagram of a radio communication equipment according to a preferred embodiment of the present invention. In this preferred embodiment the radio communication equipment is a mobile radio terminal 1.

The mobile radio terminal 1 comprises an RF unit 2 that is connected to an antenna switch 16 and auxiliary means 15.

The RF unit 2 is adapted to receive an RF input signal via a signal line. Said RF input signal is received by the antenna switch 16 via an antenna 17 connected to the antenna switch 16. Based on the received RF input signal the RF unit 2 generates a corresponding output signal by using an RF signal processor 14. The output signal is output to the auxiliary means 15.

Said auxiliary means 15 (among other elements like memories and batteries) comprise output means such as a loudspeaker and a display to output the output signal received from the RF unit 2.

Furthermore, the RF unit 2 is adapted to receive an input signal from the auxiliary means 15 which further might comprise input means like a microphone or switches. Based on said input signal the RF unit 2 generates an RF signal by using the RF signal processor 14.

The RF signal generated by the RF signal processor 14 is amplified by the RF unit 2 to generate an RF output signal having a suitable power. Said RF output signal is output to the antenna switch 16 via a signal line 3 for transmission via the antenna 17 to provide wireless communication.

Thus, the RF unit 2 is further adapted to generate an RF output signal for wireless communication and to output said RF output signal via said signal line 3.

In the following, the internal structure of the RF unit 2 according to the present invention is further explained.

The RF signal processor 14 comprised in the RF unit 2 is connected via a second band-pass filter 12 to an adjustable amplifier 4.

The adjustable amplifier 4 is adapted to amplify the power of the RF signal produced by the RF signal processor 14 and to output the RF output signal.

The RF output signal produced by the adjustable amplifier 4 is further transmitted to the antenna switch 16 via the signal line 3 by passing through a gyrator 13, a frequency sensor 8, a power detector 6 and a first band-pass filter 11.

Furthermore, a power controller 5 for controlling the power of the RF output signal amplified by said adaptable amplifier 4 is provided.

Since the adjustable amplifier is not an ideal one its gain depends on both the temperature of the adjustable amplifier and the frequency. Thus, in addition to the general control of the adjustable amplifier the power controller 5 tries to overcome the temperature and frequency dependencies of the adjustable amplifier.

The power controller 5 is connected to the power detector 6.

In the present embodiment said power detector 6 is a directional coupler 6.
Alternatively a resistive coupler might be used.

The directional coupler 6 is coupled to the signal line 3 and outputs a detection signal (couple signal) depending on the power of the RF output signal transmitted via said signal line 3.

In this respect it is important to emphasise that directional couplers in general have a relative high power dynamic and a low temperature variation. Furthermore, the influence of the directional coupler 3 on the RF output signal transmitted via said signal line 3 is very small.

Furthermore, the power controller 5 is connected to a temperature sensor 7. The temperature sensor 7 measures the temperature of the RF unit 2 and / or the RF signal processor 14 and especially of the adjustable amplifier 4 and outputs a corresponding temperature signal.

Moreover, the power controller 5 is connected to a frequency sensor 8 that measures the frequency of the RF output signal amplified and transmitted by said adjustable amplifier 4 via said signal line 3 and outputs a frequency signal.

Alternatively said frequency signal might be provided to said power controller 5 by said RF signal processor 14. In this case the provision of a separate frequency sensor can be avoided.

Finally, the power controller 5 comprises a non-volatile memory 9. At least one predefined gain compensation table 10 is stored in said non-volatile memory.

As it is shown in Fig. 3 said gain compensation table 10 comprises predefined gain compensation values G_{0.0}, G_{1.0}, G_{0.1}, ..., G_{11.7} for pairs of predefined frequency and temperature values.

Furthermore, predefined threshold values are stored in the memory 9 of said power controller 5.

In the present preferred embodiment, two threshold values are provided. A first threshold value tₘₐₓ corresponds to the intended maximum power of the RF output signal. A second threshold value tₘᵢₙ corresponds to the intended maximum power of the RF output signal minus a constant. In the present embodiment said constant is 1 dB. It is obvious that the constant alternatively might be any other value.

In this respect it is preferred that the second threshold value tₘᵢₙ still is in the proximity of the intended maximum power of the RF output signal.

During operation of the inventive RF unit 2 the power controller 5 permanently or sequentially compares the detection signal output by the directional coupler 6 with both the lower and higher threshold values tₘᵢₙ, tₘₐₓ stored in the memory 9.

In case the power controller 5 decides based on the comparison result that the power of the RF output signal amplified and transmitted via the signal line 3 by said adjustable amplifier 4 still is below the lower threshold value tₘᵢₙ, the gain of the adjustable amplifier 4 is controlled by the power controller 5 by using the corresponding gain compensation values G_{0.0}, G_{1.0}, G_{0.1}, ..., G_{11.7} of said gain compensation table 10 stored in said memory 9, only.

Thus, the power controller 5 selects the gain compensation value G_{f.t} that corresponds to the frequency signal f currently output by the frequency sensor 8 and the temperature signal t currently output by the temperature sensor 7 and controls the adjustable amplifier 4 correspondingly. Therefore, a correction of the gain of the adjustable amplifier 4 for a respective temperature and / or frequency is possible by using the respective gain compensation value G_{f,t}. In consequence, gain dependencies of the adjustable amplifier 4 on temperature and / or frequency variations are accounted for.

Although the power controller 5 considers both the temperature signal output by said temperature sensor 7 and the frequency signal output by said frequency sensor 8 to chose a suitable gain compensation value G_{f.t} to adjust said adjustable amplifier 4, an open loop control exclusively is used if the power of the RF output signal is below the lower threshold value tₘᵢₙ. Thus, the adjustable amplifier 4 is adjusted by the power controller 5 independent from the actual power of the RF output signal according to predefined rules.

The exclusive usage of an open loop control if the power of the RF output signal is below said lower threshold value tₘᵢₙ allows a relatively easy control of the power of the RF output signal with high dynamic.

The usage of a predefined gain compensation table 10 reduces the necessary calculations for performing power control by the power controller 5 and thus increases the velocity of gain control and thus provides an easy and reliable open loop control. Furthermore, frequency dependencies or temperature dependencies of the various elements of the RF unit 2 (that e.g. might have been analysed in a laboratory) can be accounted for. In consequence, even in cases where the directional coupler 6 is not used for power control a suitable power control of the power of the RF output signal is guaranteed.

In case the power controller 5 decides based on the comparison of the detection signal with the lower and higher threshold values **t**ₘᵢₙ, tₘₐₓ that the power oft he RF output signal amplified and transmitted by the adjustable amplifier 4 via said signal line 3 is above the lower threshold value tₘᵢₙ, the power controller determines a difference between the actual detection signal output by said directional coupler 6 and the lower and higher threshold values tₘᵢₙ, tₘₐₓ, respectively.

Based on said difference, the power controller 5 corrects the compensation value G_{f.t} that corresponds to the actual frequency signal f and the actual temperature signal t in a way that the power of the RF output signal amplified and transmitted by the adjustable amplifier 4 via said signal line 3 does not exceed the higher threshold value tₘₐₓ. In consequence, by the usage of the detection signal output by said directional coupler 6 to adjust the adjustable amplifier 4 the existing open loop control is modified to be a closed loop control for this range of the power of the RF output signal in a very easy way.

Due to the inventive combination of said open loop control with said closed loop control (that is used if the power of the RF output signal exceeds said lower threshold value **t**ₘᵢₙ, only), the accuracy of said control significantly is increased for critical power ranges of the RF output signal. In consequence, the accuracy of controlling critical power ranges of the RF output signal is limited by the accuracy of the power controller, the directional coupler and the adjustable amplifier, only.

Since control by said closed loop control is limited to a narrow range (between the lower and higher threshold values tₘᵢₙ, tₘₐₓ) the closed loop control does not have to scope with high ranges of dynamic. In consequence, a simple and thus cheap closed loop control can be used.

Generally a directional or resistive coupler plus a standard RF detector and an A/D converter are sufficient. Due to the small number of additional elements and the simplicity of said elements the additional costs are very low.

In the present embodiment, the lower threshold value tₘᵢₙ is used to restrict adjustment of the adjustable amplifier 4 by using the directional coupler 6 to a power range of the RF output signal close to the intended maximum output power. Thus, by the comparison of the lower and higher threshold values tₘᵢₙ, tₘₐₓ with the detection signal it is determined whether a correction of the gain of the adjustable amplifier 4 by using the detection signal is required.

Alternatively, a separate threshold value might be defined.

In consequence, by the exclusive use of the gain compensation table 10 at a power range of the RF-output signal below the lower threshold value tₘᵢₙ a linear gain of the adjustable amplifier 4 can be guaranteed. Furthermore, said exclusive usage of an open loop control if the power of the RF output signal is below said lower threshold value **t**ₘᵢₙ allows a relatively easy control of the power of the RF output signal with high dynamic.

In the above described embodiment, differences between the actual detection signal output by said directional coupler 6 and the lower and higher threshold values tₘᵢₙ, have been used to correct the gain compensation value G_{f.t} that corresponds to the actual frequency signal f and the actual temperature signal t. This allows a linear adjustment of the respective gain compensation value G_{f.t} in dependency on the aberration from the lower and higher threshold values tₘᵢₙ, tₘₐₓ.

Alternatively said correction directly might be performed based on the detection signal, only.

In the present embodiment, the correction of the gain compensation values G_{0.0}, G_{1.0}, G_{0.1}, ..., G_{11.7} of said gain compensation table 10 is deleted when the mobile radio terminal 1 is switched off and/or a wireless communication is terminated.

Alternatively, the corrected gain compensation values G_{0.0}, G_{1.0}, G_{0.1}, ..., G_{11.7} may be stored either temporarily or permanently in a corrected compensation table 10. A corresponding radio communication equipment constitutes a self-learning system.

Although the compensation table 10 shown in Fig. 3 comprises gain compensation values for twelve different frequencies and eight different temperatures, only, gain compensation values for a different number of frequencies and/or temperatures can be included in the compensation table 10. Furthermore, plural predefined compensation tables can be provided.

In the above-described preferred embodiment the frequency of the actual RF signal and the temperature of the RF unit are used together with the detection signal output by the directional coupler 6 to control the adjustable amplifier 4 according to the compensation table 10. According to an alternative embodiment the adjustable amplifier 4 is controlled by said power controller 5 based on the detection signal output by the directional coupler 5, only, if the power of the RF output signal exceeds the lower threshold value tₘᵢₙ.

According to another alternative embodiment, the frequency of the actual RF signal and/or the temperature of the RF unit is considered by the power controller 5 in addition to the detection signal to control the adjustable amplifier 4 if the actual power of the RF output signal exceeds the lower threshold value tₘᵢₙ.

According to a further alternative embodiment, the compensation table 10 is considered by the power controller 5 in addition to the detection signal to control the adjustable amplifier 4 if the actual power of the RF output signal exceeds the lower threshold value tₘᵢₙ.

Although different components are used in the above described preferred embodiment for the RF unit 2, the adjustable amplifier 4, the power controller 5, the directional coupler 6, the temperature sensor 7, the frequency sensor 8, the first and second band-pass filters 11, 12 and the gyrator 13, all or plural of said elements might be implemented in one single element (e.g. the RF unit, for example).

In summary the inventive RF unit 2 for a radio communication equipment provides an easy and accurate control of the power of the RF output signal generated by the RF unit 2. Furthermore, said control is realised by using cheap components.

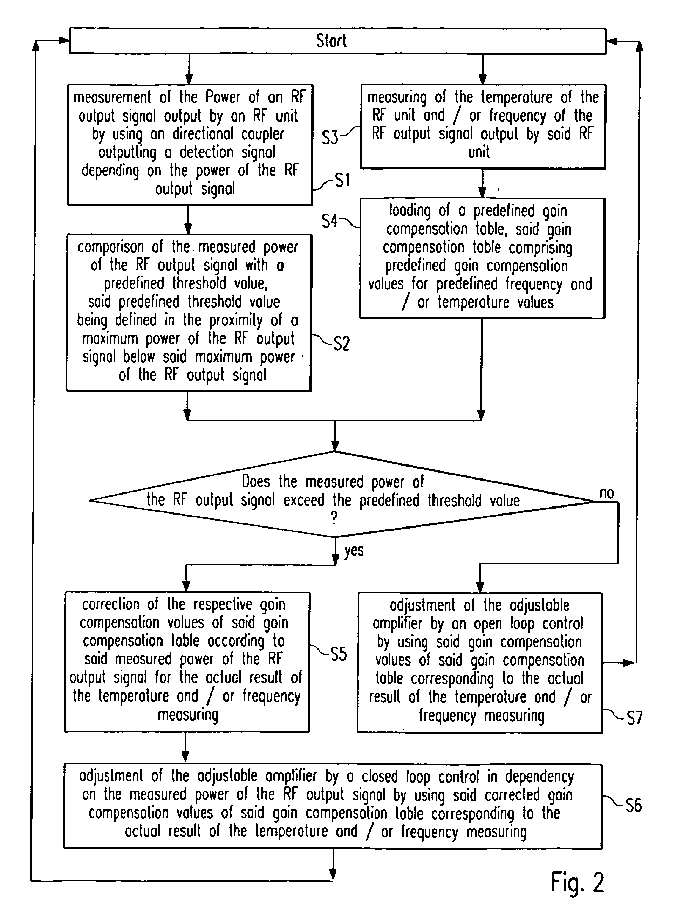

In the following, the inventive method of controlling the power of the RF output signal output by an RF unit 2 of a radio communication equipment 1 is further explained by reference to Figs. 1 and 2.

In a first step S1 the power of an RF output signal output by an RF unit 2 is measured by using a directional coupler 6 (power detector) that outputs a detection signal depending on the power of the RF output signal.

In the following step S2 the measured power of the RF output signal is compared with a predefined threshold value, said predefined threshold value being defined in the proximity of a maximum power of the RF output signal below said maximum power of the RF output signal. Alternatively a different threshold value might be used.

In a parallel step S3 a temperature of the RF unit 3 and/or a frequency of the RF output signal output by said RF unit 2 are measured.

In the following step S4 a predefined gain compensation table 10 is loaded, wherein said gain compensation table comprises predefined gain compensation values G_{0.0}, G_{1.0}, G_{0.1}, ..., G_{x.y} for predefined pairs of frequency and / or temperature values.

After steps S2 and S4, respectively, it is decided whether the measured power of the RF output signal exceeds the predefined threshold value.

If it is decided that the measured power of the RF output signal exceeds the predefined threshold value, correction of the respective gain compensation values G_{f.t} of said gain compensation table 10 is performed in step S5 according to said measured power of the RF output signal for the actual result of the temperature and / or frequency measuring of step S3.

According to an alternative embodiment that is not shown in the figures the corrected gain compensation values G_{f.t} are stored in a corrected gain compensation table 10.

Afterwards, adjustment of the adjustable amplifier 4 by a closed loop control in dependency on the measured power of the RF output signal (see step S1) by using said corrected gain compensation values G_{f.t} of said (corrected) gain compensation table 10 corresponding to the actual result of the temperature and / or frequency measuring is performed in step S6.

On the other hand, if it is decided that the measured power of the RF output signal does not exceed the predefined threshold value, adjustment of the adjustable amplifier 4 by an open loop control is performed in step S7 by using the respective gain compensation values G_{f.t} of said gain compensation table 10 corresponding to the actual result of the temperature and / or frequency measuring, respectively.

After steps S6 and S7, the method is looped to start, respectively.

Thus, by using the inventive method, the power of the RF output signal output by the RF unit 2 can be controlled in an accurate, easy and reliable way. Moreover, combination of an open loop control and a closed loop control is possible.

The above method preferably is implemented into a computer program product comprising a series of state elements which are adapted to be processed by a data processing means of a radio communication equipment 1 such, that a method according to one of the claims 12 to 18 may be executed thereon.

## Claims

1. RF unit (2) to be used in a radio communication equipment (1) for wireless communication,
the RF unit (2) being adapted to generate an RF output signal and to output said RF output signal via a signal line (3),
wherein said RF unit (2) comprises at least one adjustable amplifier (4) for amplifying the RF output signal and outputting said RF output signal via said signal line (3) and a power controller (5) for controlling the power of the RF output signal amplified by said amplifier (4) by adjusting said adjustable amplifier (4), the adjustment of said adjustable amplifier (4) being performed by said power controller (5) by an open loop control,
wherein
the RF unit (2) further comprises a power detector (6) coupled to said signal line (3), the power detector (6) outputting a detection signal depending on the power of the RF output signal transmitted via said signal line (3) to said power controller (5),
wherein the detection signal output by said power detector (6) is used by said power controller (5) to adjust said adjustable amplifier (3) by a closed loop control if the power of the RF output signal exceeds a predefined threshold value stored in said power controller (5), **characterised in that** the predefined threshold value is defined in the proximity of a maximum power of the RF output signal amplified by said amplifier (4) below said maximum power of the RF output signal.

2. RF unit (2) according to claim 1,
**characterised in that**
the open loop control is performed by said power controller (5) independent from the actual power of the RF output signal amplified by said amplifier (4) according to predefined rules.

3. RF unit (2) according to claim 1 or 2,
**characterised in that**
the power detector (6) is a directional coupler coupled to said signal line (3).

4. RF unit (2) according to one of the preceding claims,
**characterised in that**
the power controller (5) compares the detection signal output by said power detector (6) with said predefined threshold value and adjusts the adjustable amplifier (4) based on a difference between said threshold value and the detection signal output by said power detector (6).

5. RF unit (2) according to one of the preceding claims,
**characterised in that**
the power controller (5) further comprises a temperature sensor (7) for measuring the temperature of the RF unit (2) and outputting a corresponding temperature signal,
wherein the temperature signal output by said temperature sensor (7) is used by said power controller (5) to adjust the adjustable amplifier (4).

6. RF unit (2) according to one of the preceding claims,
**characterised in that**
the power controller (5) further comprises a frequency sensor (8) for measuring the frequency of the RF output signal transmitted via said signal line (3) and outputting a frequency signal,
wherein the frequency signal output by said frequency sensor (8) is used by said power controller (5) to adjust the adjustable amplifier (4).

7. RF unit (2) according to one of the claims 5 or 6,
**characterised in that**
the power controller (5) further comprises a memory (9) for storing at least one predefined gain compensation table (10), said gain compensation table (10) comprising predefined gain compensation values (G_{0.0}, G_{1.0}, G_{0.1}, G_{11.7}) for predefined frequency and / or temperature values,
wherein said gain compensation values (G_{0.0}, G_{1.0}, G_{0.1}, G_{11.7}) of said gain compensation table (10) stored in said memory (9) are used by said power controller (5) to adjust the adjustable amplifier depending on the respective frequency signal output by the frequency sensor (8) and / or the respective temperature signal output by the temperature sensor (7).

8. RF unit (2) according to claim 7,
**characterised in that**
the detection signal output by the power detector (6) is used by the power controller (5) to correct the respective compensation values (G_{0.0}, G_{1.0}, G_{0.1}, G_{11.7}) of a respective gain compensation table (10) for the respective frequency signal output by the frequency sensor (8) and / or the respective temperature signal output by the temperature sensor (7).

9. RF unit (2) according to one of the preceding claims,
**characterised in that**
the RF unit (2) is connected via the signal line (3) to a sending / receiving unit (16) of a radio communication equipment (1) for wireless sending and receiving of an RF signal, wherein said RF unit (2) is adapted to output the RF output signal to said sending / receiving unit (1) via said signal line (3).

10. RF unit (2) according to one of the preceding claims,
**characterised in that**
the RF unit (2) is comprised in a mobile radio terminal.

11. Method of controlling the power of an RF output signal output by an RF unit (2),
wherein said RF unit (2) comprises at least one adjustable amplifier (4) for amplifying the RF output signal, the method comprising the following steps:
- (S1) measurement of the power of the RF output signal output by said RF unit (2);
- (S2) comparison of the measured power of the RF output signal with a predefined threshold value;
- (S7) adjustment of the adjustable amplifier (4) by an open loop control if the measured power of the RF output signal is below the predefined threshold value; and
- (S6) adjustment of the adjustable amplifier (4) by a closed loop control in dependency on the measured power of the RF output signal if the measured power of the RF output signal exceeds the predefined threshold value, **characterised in that** said predefined threshold value is defined in the proximity of a maximum power of the RF output signal below said maximum power of the RF output signal.

12. Method according to claim 11,
**characterised in that**
said adjustment (S7) of the adjustable amplifier (4) by an open loop control is performed independent from the measured power of the RF output signal according to predefined rules.

13. Method according to claim 12, 13 or 14,
**characterised in that**
the measurement (S1) of the power of the RF output signal is performed by using a directional coupler (6) outputting a detection signal depending on the power of the RF output signal.

14. Method according to one of the claims 11 to 13,
**characterised in that**
the method further comprises the step of
- (S3) measuring of a temperature of the RF unit (2) and / or a frequency of the RF output signal output by said RF unit (2);
wherein the adjustment (S7) of the adjustable amplifier (4) is performed according to the result or the temperature and / or frequency measuring (S3).

15. Method according to claim 14,
**characterised in that**
the method further comprises the step of
- (S4) loading of a predefined gain compensation table (10), said gain compensation table (10) comprising predefined gain compensation values (G_{0.0}, G_{1.0}, G_{0.1}, G_{11.7}) for predefined frequency and / or temperature values;
wherein the adjustment (S7) of the adjustable amplifier (4) is performed by using said gain compensation values (G_{0.0}, G_{1.0}, G_{0.1}, G_{11.7}) of said gain compensation table (10) corresponding to the actual result of the temperature and / or frequency measuring (S4).

16. Method according to claim 15,
**characterised in that**
the method further comprises the step of
- (S5) correction of the respective gain compensation values (G_{0.0}, G_{1.0}, G_{0.1}, G_{11.7}) of said gain compensation table (10) according to said measured power of the RF output signal for the actual result of the temperature and / or frequency measuring (S3) if the measured power of the RF output signal exceeds the predefined threshold value;
wherein the adjustment (S6) of the adjustable amplifier (4) is performed by using said corrected gain compensation values (G_{0.0}, G_{1.0}, G_{0.1}, G_{11.7}) of said gain compensation table (10) corresponding to the actual result of the temperature and / or frequency measuring (S4) if the measured power of the RF output signal exceeds the predefined threshold value.

17. Computer program product comprising a series of state elements which are adapted to be processed by a data processing means of a radio communication equipment (1) such, that a method according to one of the claims 11 to 16 may be executed thereon.

## Patentansprüche

1. HF-Baugruppe (2), welche in einer Funkkommunikationseinrichtung (1) zur drahtlosen Kommunikation zu verwenden ist,
wobei die HF-Baugruppe (2) angepasst ist, ein HF-Ausgangssignal zu erzeugen und um das HF-Ausgangssignal über eine Signalleitung (3) auszugeben,
wobei die HF-Baugruppe (2) zumindest einen einstellbaren Verstärker (4) aufweist, um das HF-Ausgangssignal zu verstärken und um das HF-Ausgangssignal über die Signalleitung (3) auszugeben, und eine Leistungssteuerung (5), um die Leistung des HF-Ausgangssignals, welches durch den Verstärker (4) verstärkt wurde, zu steuern, indem der einstellbare Verstärker (4) eingestellt wird, wobei das Einstellen des einstellbaren Verstärkers (4) durch die Leistungssteuerung (5) durch eine offene Schleifensteuerung durchgeführt wird,
wobei
die HF-Baugruppe (2) außerdem einen Leistungsdetektor (6) aufweist, der mit der Signalleitung gekoppelt ist, wobei der Leistungsdetektor (6) ein Erfassungssignal in Abhängigkeit von der Leistung des HF-Ausgangssignals ausgibt, welches über die Signalleitung (3) zur Leistungssteuerung (5) übertragen wird,
wobei das Erfassungssignal, welches durch den Leistungsdetektor (6) ausgegeben wird, durch die Leistungssteuerung (5) verwendet wird, um den einstellbaren Verstärker (3) über eine geschlossene Schleifensteuerung einzustellen, wenn die Leistung des HF-Ausgangssignals einen vorher festgelegten Schwellenwert übersteigt, der in der Leistungssteuerung (5) gespeichert ist, **dadurch gekennzeichnet, dass** der vorher festgelegte Schwellenwert in der Nähe einer maximalen Leistung des HF-Ausgangssignals, welches durch den Verstärker (4) verstärkt wurde, unterhalb der maximalen Leistung des HF-Ausgangssignals definiert ist.

2. HF-Baugruppe (2) nach Anspruch 1,
**dadurch gekennzeichnet, dass**
die offene Schleifensteuerung durch die Leistungssteuerung (5) unabhängig von der tatsächlichen Leistung des HF-Ausgangssignals, welches durch den Verstärker (4) verstärkt wurde, gemäß vorher festgelegten Regeln durchgeführt wird.

3. HF-Baugruppe (2) nach Anspruch 1 oder 2
**dadurch gekennzeichnet, dass**
der Leistungsdetektor (6) ein Richtungskoppler ist, der mit der Signalleitung (3) gekoppelt ist.

4. HF-Baugruppe (2) nach einem der vorhergehenden Ansprüche,
**dadurch gekennzeichnet, dass**
die Leistungssteuerung (5) das Erfassungssignal, welches durch den Leistungsdetektor (6) ausgegeben wird, mit dem vorher festgelegten Schwellenwert vergleicht und den einstellbaren Verstärker (4) auf Basis einer Differenz zwischen dem Schwellenwert und dem Erfassungssignal, welches durch den Leistungsdetektor (6) ausgegeben wird, einstellt.

5. HF-Baugruppe (2) nach einem der vorhergehenden Ansprüche,
**dadurch gekennzeichnet, dass**
die Leistungssteuerung (5) außerdem einen Temperatursensor (7) aufweist, um die Temperatur der HF-Baugruppe (2) zu messen und um ein entsprechendes Temperatursignal auszugeben, wobei das Temperatursignal, welches durch den Temperatursensor (7) ausgegeben wird, durch den Leistungsverstärker (5) verwendet wird, um den einstellbaren Verstärker (4) einzustellen.

6. HF-Baugruppe (2) nach einem der vorhergehenden Ansprüche,
**dadurch gekennzeichnet, dass**
die Leistungssteuerung (5) außerdem einen Frequenzsensor (8) aufweist, um die Frequenz des HF-Ausgangssignals zu messen, welches über die Signalleitung (3) übertragen wird, und um ein Frequenzsignal auszugeben,
wobei das Frequenzsignal, welches durch den Frequenzsensor (8) ausgegeben wird, durch die Leistungssteuerung (5) verwendet wird, um den einstellbaren Verstärker (4) einzustellen.

7. HF-Baugruppe (2) nach einem der Ansprüche 5 oder 6
**dadurch gekennzeichnet, dass**
die Leistungssteuerung (5) außerdem einen Speicher (9) aufweist, um zumindest eine vorher festgelegte Verstärkungsfaktor-Kompensationstabelle (10) zu speichern, wobei die Verstärkungsfaktor-Kompensationstabelle (10) vorher festgelegte Verstärkungsfaktor-Kompensationswerte (G_{0,0}, G_{1,0}, G_{0,1}, G_{11,7}) für vorher festgelegte Frequenz- und/oder Temperaturwerte aufweist,
wobei die Verstärkungsfaktor-Kompensationswerte (G_{0,0}, G_{1,0}, G_{0,1}, G_{11,7}) der Verstärkungsfaktor-Kompensationstabelle (10), welche im Speicher (9) gespeichert sind, durch die Leistungssteuerung (5) verwendet werden, um den einstellbaren Verstärker in Abhängigkeit von dem entsprechenden Frequenzsignal, welches durch den Frequenzsensor (8) ausgegeben wird, und/oder des entsprechenden Temperatursignals, welches durch den Temperatursensor (7) ausgegeben wird, einzustellen.

8. HF-Baugruppe (2) nach Anspruch 7,
**dadurch gekennzeichnet, dass**
das Erfassungssignal, welches durch den Leistungsdetektor (6) ausgegeben wird, durch die Leistungssteuerung (9) verwendet wird, um die entsprechenden Kompensationswerte (G_{0,0}, G_{1,0}, G_{0,1}, G_{11,7}) einer entsprechenden Verstärkungsfaktor-Kompensationstabelle (10) für das entsprechende Frequenzsignal, welches durch den Frequenzsensor (8) ausgegeben wird, und/oder das entsprechende Temperatursignal, welches durch den Temperatursensor (7) ausgegeben wird, zu korrigieren.

9. HF-Baugruppe (2) nach einem der vorhergehenden Ansprüche,
**dadurch gekennzeichnet, dass**
die HF-Baugruppe (2) über die Signalleitung (3) mit einer Sende-/Empfangsbaugruppe (16) der Funkkommunikationseinrichtung (1) zum drahtlosen Senden und Empfangen eines HF-Signals verbunden ist, wobei die HF-Baugruppe (2) ausgebildet ist, das HF-Ausgangssignal über die Signalleitung (3) an die Sende-/Empfangsbaugruppe (1) auszugeben.

10. HF-Baugruppe (2) nach einem der vorhergehenden Ansprüche,
**dadurch gekennzeichnet, dass**
die HF-Baugruppe (2) in einem mobilen Funkendgerät angeordnet ist.

11. Verfahren zum Steuern der Leistung eines HF-Ausgangssignals, welches durch eine HF-Baugruppe (2) ausgegeben wird, wobei die HF-Baugruppe (2) zumindest einen einstellbaren Verstärker (4) aufweist, um das HF-Ausgangssignal zu verstärken, wobei das Verfahren die folgenden Schritte aufweist:
- (S1) Messen der Leistung des HF-Ausgangssignals, welches durch die HF-Baugruppe (2) ausgegeben wird;
- (S2) Vergleichen der gemessenen Leistung des HF-Ausgangssignals mit einem vorher festgelegten Schwellenwert;
- (S7) Einstellen des einstellbaren Verstärkers (4) durch eine offene Schleifensteuerung, wenn die gemessene Leistung des HF-Ausgangssignals unterhalb eines vorher festgelegten Schwellenwerts ist; und
- (S6) Einstellen des einstellbaren Verstärkers (4) durch eine geschlossene Schleifensteuerung in Abhängigkeit von der gemessenen Leistung des HF-Ausgangssignals, wenn die gemessene Leistung des HF-Ausgangssignals den vorher festgelegten Schwellenwert übersteigt, **dadurch gekennzeichnet, dass** der vorher festgelegte Schwellenwert in der Nähe einer maximalen Leistung des HF-Ausgangssignals unterhalb der maximalen Leistung des HF-Ausgangssignals definiert wird.

12. Verfahren nach Anspruch 11,
**dadurch gekennzeichnet, dass**
die Einstellung (S7) des einstellbaren Verstärkers (4) durch eine offene Schleifensteuerung unabhängig von der gemessenen Leistung des HF-Ausgangssignals gemäß vorher festgelegter Regeln durchgeführt wird.

13. Verfahren nach Anspruch 12, 13 oder 14,
**dadurch gekennzeichnet, dass**
die Messung (S1) der Leistung des HF-Ausgangssignals unter Verwendung eines Richtungskopplers (6) durchgeführt wird, der ein Erfassungssignal in Abhängigkeit von der Leistung des HF-Ausgangssignals ausgibt.

14. Verfahren nach einem der Ansprüche 11 bis 13,
**dadurch gekennzeichnet, dass**
das Verfahren außerdem folgenden Schritt aufweist:
- (S3) Messen einer Temperatur der HF-Baugruppe (2) und/oder einer Frequenz des HF-Ausgangssignals, welches durch die HF-Baugruppe (2) ausgegeben wird;
wobei das Einstellen (S7) des einstellbaren Verstärkers (4) gemäß dem Ergebnis der Temperatur- und/oder Frequenzmessung (S3) durchgerührt wird.

15. Verfahren nach Anspruch 14,
**dadurch gekennzeichnet, dass**
das Verfahren außerdem folgenden Schritt aufweist:
- (S4) Laden einer vorher festgelegten Verstärkungsfaktor-Kompensationstabelle (10), wobei die Verstärkungsfaktor-Kompensationstabelle (10) vorher festgelegte Verstärkungsfaktor-Kompensationswerte (G_{0,0}, G_{1,0}, G_{0,1}, G_{11,7}) für vorher festgelegte Frequenz- und/oder Temperaturwerte aufweist;
wobei das Einstellen (S7) des einstellbaren Verstärkers (4) unter Verwendung der Verstärkungsfaktor-Kompensationswerte (G_{0,0}, G_{1,0}, G_{0,1}, G_{11,7}) der Verstärkungsfaktor-Kompensationstabelle (10) entsprechend dem tatsächlichen Ergebnis der Temperatur- und/oder Frequenzmessung (S4) durchgeführt wird.

16. Verfahren nach Anspruch 15,
**dadurch gekennzeichnet, dass**
das Verfahren außerdem folgenden Schritt aufweist:
- (S5) Korrektur der jeweiligen Verstärkungsfaktor-Kompensationswerte (G_{0,0}, G_{1,0}, G_{0,1}, G_{11,7}) der Verstärkungsfaktor-Kompensationstabelle (10) gemäß der gemessenen Leistung des HF-Ausgangssignals für das aktuelle Ergebnis der Temperatur- und/oder Frequenzmessung (S3), wenn die gemessene Leistung des HF-Ausgangssignals den vorher festgelegten Schwellenwert übersteigt;
wobei die Einstellung (S6) des einstellbaren Verstärkers (4) unter Verwendung der korrigierten Verstärkungsfaktor-Kompensationswerte (G_{0,0}, G_{1,0}, G_{0,1}, G_{11,7}) der Verstärkungsfaktor-Kompensationstabelle (10) entsprechend dem aktuellen Ergebnis der Temperatur- und/oder Frequenzmessung (S4) durchgeführt wird, wenn die gemessene Leistung des HF-Ausgangssignals den vorher festgelegten Schwellenwert übersteigt.

17. Computerprogrammprodukt, welches eine Reihe von Zustandselementen aufweist, welche angepasst sind, durch eine Datenverarbeitungseinrichtung einer Funkkommunikationseinrichtung (1) verarbeitet zu werden, so dass ein Verfahren gemäß einem der Ansprüche 11 bis 16 dafür durchgeführt werden kann.

## Revendications

1. Module (2) RF destiné à être utilisé dans un équipement (1) de communications radio pour une communication sans fils,
le module (2) RF étant conçu pour produire un signal de sortie RF et pour fournir en sortie ledit signal de sortie RF par l'intermédiaire d'une ligne (3) de signal,
où ledit module (2) RF est constitué d'au moins un amplificateur (4) réglable destiné à amplifier le signal de sortie RF et à fournir en sortie ledit signal de sortie RF par l'intermédiaire de ladite ligne (3) de signal ainsi que d'un dispositif (5) de commande de puissance destiné à commander la puissance du signal de sortie RF amplifié par ledit amplificateur (4) en réglant ledit amplificateur (4) réglable, le réglage dudit amplificateur (4) réglable étant effectué par ledit dispositif (5) de commande de puissance au moyen d'une commande en boucle ouverte,
dans lequel
le module (2) RF est de plus constitué d'un détecteur (6) de puissance relié à ladite ligne (3) de signal, le détecteur (6) de puissance fournissant en sortie un signal de détection dépendant de la puissance du signal de sortie RF transmis par l'intermédiaire de ladite ligne (3) de signal audit dispositif (5) de commande de puissance,
où le signal de détection fourni en sortie par ledit détecteur (6) de puissance est utilisé par ledit dispositif (5) de commande de puissance pour régler ledit amplificateur (3) réglable au moyen d'une commande en boucle fermée si la puissance du signal de sortie RF est supérieure à une valeur de seuil prédéfinie stockée dans ledit dispositif (5) de commande de puissance, **caractérisé en ce que** la valeur de seuil prédéfinie est définie à proximité d'une puissance maximum du signal de sortie RF amplifié par ledit amplificateur (4) inférieure à ladite puissance maximum du signal de sortie RF.

2. Module (2) RF selon la revendication 1, **caractérisé en ce que**
la commande en boucle ouverte est effectuée par ledit dispositif (5) de commande de puissance indépendamment de la puissance réelle du signal de sortie RF amplifié par ledit amplificateur (4) selon des règles prédéfinies.

3. Module (2) RF selon la revendication 1 ou 2, **caractérisé en ce que**
le détecteur (6) de puissance est un coupleur directionnel relié à ladite ligne (3) de signal.

4. Module (2) RF selon l'une des précédentes revendications, **caractérisé en ce que**
le dispositif (5) de commande de puissance compare le signal de détection fourni en sortie par ledit détecteur (6) de puissance à ladite valeur de seuil prédéfinie et règle l'amplificateur (4) réglable sur la base d'une différence entre ladite valeur de seuil et le signal de détection fourni en sortie par ledit détecteur (6) de puissance.

5. Module (2) RF selon l'une des précédentes revendications, **caractérisé en ce que**
le dispositif (5) de commande de puissance est de plus constitué d'un capteur (7) de température pour mesurer la température du module (2) RF et fournir en sortie un signal de température correspondant, dans lequel le signal de température fourni par ledit capteur (7) de température est utilisé par ledit dispositif (5) de commande de puissance pour régler l'amplificateur (4) réglable.

6. Module (2) RF selon l'une des précédentes revendications, **caractérisé en ce que**
le dispositif (5) de commande de puissance est de plus constitué d'un capteur (8) de fréquence pour mesurer la fréquence du signal de sortie RF transmis par l'intermédiaire de ladite ligne (3) de signal et fournir en sortie un signal de fréquence,
dans lequel le signal de fréquence fourni en sortie par ledit capteur (8) de fréquence est utilisé par ledit dispositif (5) de commande de puissance pour régler l'amplificateur (4) réglable.

7. Module (2) RF selon l'une des revendications 5 ou 6, **caractérisé en ce que**
le dispositif (5) de commande de puissance est de plus constitué d'une mémoire (9) pour stocker au moins une table (10) de compensation de gain prédéfinie, ladite table (10) de compensation de gain étant constituée de valeurs (G_{0.0}, G_{1.0}, G_{0.1}, G_{11.7}) de compensation de gain prédéfinies pour des valeurs de fréquence et / ou de température prédéfinies,
où lesdites valeurs (G_{0.0}, G_{1.0}, G_{0.1}, G_{11.7}) de compensation de gain de ladite table (10) de compensation de gain stockée dans ladite mémoire (9) sont utilisées par ledit dispositif (5) de commande de gain pour régler l'amplificateur réglable en fonction du signal de fréquence respectif fourni en sortie par le capteur (8) de fréquence et / ou du signal de température respectif fourni en sortie par le capteur (7) de température.

8. Module (2) RF selon la revendication 7,
**caractérisé en ce que**
le signal de détection fourni en sortie par le détecteur (6) de puissance est utilisé par le dispositif (5) de commande de puissance pour corriger les valeurs (G_{0.0}, G_{1.0}, G_{0.1}, G_{11.7}) de compensation respectives d'une table (10) de compensation de gain respective pour le signal de fréquence respectif fourni en sortie par le capteur (8) de fréquence et / ou le signal de température respectif fourni en sortie par le capteur (7) de température.

9. Module (2) RF selon l'une quelconque des précédentes revendications, **caractérisé en ce que**
le module (2) RF est raccordé par l'intermédiaire de la ligne (3) de signal à un module (16) d'envoi / réception d'un équipement (1) de communications radio pour un envoi et une réception sans fils d'un signal RF, où ledit module (2) RF est conçu pour fournir en sortie le signal de sortie RF audit module (1) d'envoi / de réception par l'intermédiaire de ladite ligne (3) de signal.

10. Module (2) RF selon l'une quelconque des précédentes revendications, **caractérisé en ce que**
le module (2) RF est compris dans un terminal radio mobile.

11. Procédé pour commander la puissance d'un signal de sortie RF fourni en sortie par un module (2) RF, dans lequel ledit module (2) RF est constitué d'au moins un amplificateur (4) réglable destiné à amplifier le signal de sortie RF, le procédé étant constitué des étapes suivantes :
- (S1) de mesure de la puissance du signal de sortie RF fourni en sortie par ledit module (2) RF ;
- (S2) de comparaison de la puissance mesurée du signal de sortie RF avec une valeur de seuil prédéfinie ;
- (S7) de réglage de l'amplificateur (4) réglable par une commande en boucle ouverte si la puissance mesurée du signal de sortie RF est inférieure à la valeur de seuil prédéfinie ; et
- (S6) de réglage de l'amplificateur (4) réglable par une commande en boucle fermée en fonction de la puissance mesurée du signal de sortie RF si la puissance mesurée du signal de sortie RF est supérieure à la valeur de seuil prédéfinie, **caractérisé en ce que** ladite valeur de seuil prédéfinie est définie à proximité d'une puissance maximum du signal de sortie RF inférieure à ladite puissance maximum du signal de sortie RF.

12. Procédé selon la revendication 11, **caractérisé en ce que**
ledit réglage (S7) de l'amplificateur (4) réglable par une commande en boucle ouverte est effectué indépendamment de la puissance mesurée du signal de sortie RF selon des règles prédéfinies.

13. Procédé selon la revendication 12, 13 ou 14, **caractérisé en ce que**
la mesure (S1) de la puissance du signal de sortie RF est effectuée en utilisant un coupleur (6) directionnel fournissant en sortie un signal de détection dépendant de la puissance du signal de sortie RF.

14. Procédé selon l'une des revendications 11 à 13, **caractérisé en ce que**
le procédé est de plus constitué de l'étape
- (S3) de mesure d'une température du module (2) RF et / ou d'une fréquence du signal de sortie RF fourni en sortie par ledit module (2) RF ;
où le réglage (S7) de l'amplificateur (4) réglable est effectué conformément au résultat de la mesure (S3) de température et / ou de fréquence.

15. Procédé selon la revendication 14, **caractérisé en ce que**
le procédé est de plus constitué de l'étape
- (S4) de chargement d'une table (10) de compensation de gain prédéfinie, ladite table (10) de compensation de gain étant constituée de valeurs (G_{0.0}, G_{1.0}, G_{0.1}, G_{11.7}) de compensation de gain prédéfinies pour des valeurs de fréquence et / ou de température prédéfinies ;
où le réglage (S7) de l'amplificateur (4) réglable est effectué en utilisant lesdites valeurs (G_{0.0}, G_{1.0}, G_{0.1}, G_{11.7}) de compensation de gain de ladite table (10) de compensation de gain correspondant au résultat réel de la mesure (S4) de température et / ou de fréquence.

16. Procédé selon la revendication 15, **caractérisé en ce que**
le procédé est de plus constitué de l'étape
- (S5) de correction des valeurs (G_{0.0}, G_{1.0}, G_{0.1}, G_{11.7}) de compensation de gain respectives de ladite table (10) de compensation de gain conformément à ladite puissance mesurée du signal de sortie RF pour le résultat réel de la mesure (S3) de température et / ou de fréquence si la puissance mesurée du signal de sortie RF est supérieure à la valeur de seuil prédéfinie ;
où le réglage (S6) de l'amplificateur (4) réglable est effectué en utilisant lesdites valeurs (G_{0.0}, G_{1.0}, G_{0.1}, G_{11.7}) de compensation de gain corrigées de ladite table (10) de compensation de gain correspondant au résultat réel de la mesure (S4) de température et / ou de fréquence si la puissance mesurée du signal de sortie RF est supérieure à la valeur de seuil prédéfinie.

17. Produit de programme informatique constitué d'une série d'éléments d'état qui sont conçus pour être traités par un moyen de traitement de données d'un équipement (1) de communications radio de sorte qu'un procédé selon l'une des revendications 11 à 16 peut être exécuté sur celui-ci.
